# EUROPÄISCHE PATENTSCHRIFT

(11) **EP 0 836 369 B1**
(45) Veröffentlichungstag und Bekanntmachung des Hinweises auf die Patenterteilung: **19.05.2004**
(21) Anmeldenummer: 97202818.7
(22) Anmeldetag: 15.09.1997
(51) Int. Cl.: H05K 1/11, H01L 23/66, H05K 1/02

(54) **Leiterplatte**
Printed circuit board
Carte imprimée

(30) Priorität: 25.09.1996 DE 19639369
(43) Veröffentlichungstag der Anmeldung: 15.04.1998
(73) Patentinhaber: Skyware Radio Systems GmbH, 47809 Krefeld (DE)
(72) Erfinder: Schiltmans, Ronald, Röntgenstrasse 24, 22335 Hamburg (DE); Avramis, Evangelos, Röntgenstrasse 24, 22335 Hamburg (DE)
(74) Vertreter: Kreutzer, Ulrich, Dipl.-Phys.

(56) Entgegenhaltungen:
- EP-A- 0 600 488
- GB-A- 2 025 146
- US-A- 5 095 407
- PATENT ABSTRACTS OF JAPAN vol. 095, no. 005, 30.Juni 1995 & JP 07 045962 A (FUJITSU LTD), 14.Februar 1995,
- PATENT ABSTRACTS OF JAPAN vol. 095, no. 011, 26.Dezember 1995 & JP 07 221461 A (HITACHI LTD), 18.August 1995,

## Beschreibung

Die Erfindung bezieht sich auf eine Leiterplatte mit einer auf ihrer Unterseite angeordneten Metallschicht und mit auf ihrer Oberseite angeordneten HF-Bausteinen, die eingangsseitig und/oder ausgangsseitig über Mikrostreifen-Zuleitungen mit HF-Quellen, HF-Senken oder anderen HF-Bausteinen und über eine gesonderte Zuleitung mit einer Gleichstromquelle verbindbar sind.

Bekannte Leiterplatten dieser Art besitzen eine isolierende Tragplatte, an deren Oberseite eine erste Elektrode zur Bildung der genannten Mikrostreifen-Leitungen angeordnet ist ("Integrierte Mikrowellenschaltungen" von Reinmut K. Hoffmann, Springer Verlag 1983, S. 142-144).. Eine zweite Elektrode zur Bildung der Mikrostreifen-Leitungen ist in Form einer Metallisierung der gesamten Fläche auf der Unterseite der Trägerplatte ausgeführt. Diese Metallschicht dient auch zur Ableitung des Gleichstromes. Die auf der Oberseite der Leiterplatte angeordneten, mit den Mikrostreifen-Zuleitungen verbundenen Hochfrequenz(HF)-Bausteine sind teilweise über direkte Verbindungen durch die isolierende Platte hindurch mit der Metallschicht auf der Unterseite verbunden. Über die Mikrostreifen-Leitungen werden die HF-Signale zu den Toren des HF-Bausteines geführt. Zur verlustfreien und reflexionsarmen Übertragung der HF-Energie ist die Metallschicht auf der Unterseite der Mikrostreifen-Leitungen nicht unterbrochen und weist mindestens eine Breite auf, die etwa ein- bis dreimal so groß ist wie die Breite der Leitung auf der Oberseite. Aus dem gleichen Grund ist eine direkte und möglichst kurze Verbindung der HF-Masse-Anschlüsse der HF-Bausteine mit der Metallschicht auf der Unterseite erforderlich. Die von den HF-Bausteinen geführten Ströme haben z.B. eine Frequenz im Zuleitungsbereich von ca. 10 GHz bis 13 GHz und im Ableitungsbereich für den Fall, daß der HF-Baustein einen Umsetzer darstellt, eine Frequenz von z.B. 1 GHz bis 3 GHz.

Unabhängig von den Hochfrequenzströmen werden die einzelnen HF-Bausteine von einer Gleichspannungsquelle mit Gleichstrom versorgt, der in Stromversorgungseingänge der HF-Bausteine eintritt und über direkte Verbindungen der HF-Bausteine durch die isolierende Platte hindurch in die metallische Ableitungsschicht an der Unterseite der Leiterplatte abgeleitet wird. Bei bekannten Bauarten dient zur Stromversorgung bisher eine Gleichspannungsquelle von z.B. 6 V, wobei z.B. zwei HF-Bausteine, z.B. IC's, gleichstrommäßig parallelgeschaltet sind, so daß an jedem Baustein eine Gleichspannung von 6 V liegt und durch jeden Baustein z.B. 100 mA fließen. Dies bedeutet, daß die gemeinsame Zuleitung für die beiden HF-Bausteine einen Strom von 200 mA führt. Ein derartiger Stromwert ist jedoch für einige Anwendungen zu hoch. Eine Lösung könnte darin bestehen, daß eine Spannungsquelle von z.B. 12 V gewählt wird und daß beide HF-Bausteine gleichstrommäßig in Reihe geschaltet werden, so daß an jedem HF-Baustein eine Spannung von 6 V anliegt. Würde man jedoch eine derartige Bauweise auf einer eingangs genannten Mikrostreifen-Leiterplatte realisieren wollen, so ergäben sich Schwierigkeiten wegen der allen Bausteinen gemeinsamen und für Mikrostreifen-Leitungen essentiellen Metallschicht an der Unterseite der Leiterplatte.

Weitere Leiterplatten sind in den Dokumenten JP7045962 und GB2025146 beschrieben.

Der Erfindung liegt die Aufgabe zugrunde, die eingangs genannte Leiterplatte derart zu gestalten, daß eine stromsparende Reihenschaltung von mindestens zwei HF-Bausteinen ermöglicht werden kann.

Diese Aufgabe wird gemäß der in Anspruch 1 beanspruchten Erfindung dadurch gelöst,
- daß die Metallschicht im Anschlußbereich mindestens eines HF-Bausteines durch einen Spalt galvanisch von der umgebenden Metallschicht getrennt ist und
- daß die so gebildete metallische Insel im Bereich unterhalb der dem HF-Baustein zugeordneten Mikrostreifen-Zuleitung HF-mäßig mit der benachbarten Metallschicht gekoppelt ist.

Auf diese Weise wird erreicht, daß die unterhalb des betreffenden HF-Bausteines gelegene Fläche unter Bildung einer metallischen Insel galvanisch völlig von der umgebenden Metallschicht getrennt ist, derart, daß die Funktion der Mikrostreifen-Leitung für den gewünschten Frequenzbereich nicht gestört wird. Somit besteht keine Gleichstromverbindung mehr zwischen der metallischen Inselfläche und der umgebenden Metallschicht auf der Unterseite der Trägerplatte. Dabei ist jedoch durch die HF-Kopplung gewährleistet, daß das zu übertragende HF-Signal praktisch ungehindert die genannte Koppelstelle passieren kann. Die Erfindung ermöglicht somit eine gleichstrommäßige Potentialtrennung von HF-Bausteinen bzw. HF-Schaltungsgruppen auf einer derartigen Leiterplatte. Eine derartige Bauweise ermöglicht eine gleichstrommäßige Reihenschaltung von mindestens zwei HF-Bausteinen, von denen der eine oberhalb der metallischen Inselfläche und der andere oberhalb der benachbarten Metallschicht auf der Leiterplatte angeordnet und durch direkte Verbindungen mit der jeweiligen Metallschicht verbunden ist. Anstelle eines HF-Bausteines kann auch eine HF-Baugruppe bzw. HF-Schaltungsgruppe mit Einzelbauelementen vorgesehen sein.

In Ausgestaltung der Erfindung ist vorgesehen, daß die HF-Kopplung durch mindestens zwei in Richtung der zugehörigen Mikrostreifen-Zuleitung verlaufende, unmittelbar nebeneinander liegende Stege gebildet wird, von denen der eine von der metallischen Insel und der andere von der benachbarten Metallschicht gebildet ist. Dabei ist in weiterer Ausgestaltung der Erfindung vorgesehen, daß das Verhältnis der Länge der Stege zur Breite sehr viel größer ist als 1.

Je nach Anwendungsfall ist in weiterer Ausgestaltung der Erfindung vorgesehen, daß die Anzahl der Stege, deren Länge, Breite und gegenseitige Abstände abhängig sind von der Frequenz und der Bandbreite der über die Mikrostreifen-Leitungen geführten HF-Signale.

Eine vorteilhafte, einfach auszuführende Bauart ist gekennzeichnet durch jeweils kammartig ausgebildete, mäanderförmig ineinander greifende Stege der metallischen Insel einerseits und der benachbarten Metallschicht andererseits. Die Anzahl, Breite und Länge derartiger Stege hängt, wie bereits erwähnt, von der Frequenz und der Bandbreite der jeweils zu übertragenden HF-Signale ab.

Die Erfindung ist gekennzeichnet durch einen ersten, oberhalb der metallischen Insel liegenden und durch einen zweiten, gleichstrommäßig in Reihe mit dem ersten geschalteten, oberhalb der benachbarten Metallschicht liegenden HF-Baustein, wobei die beiden HF-Bausteine derart an eine gemeinsame Gleichspannungsquelle geschaltet sind,
- daß der Ausgang der Spannungsquelle mit dem Stromversorgungs-Eingang des ersten HF-Bausteines verbunden ist,
- daß der Stromversorgungs-Ausgang des ersten HF-Bausteines mit der metallischen Insel verbunden ist,
- daß die metallische Insel mit dem Stromversorgungs-Eingang des zweiten HF-Bausteines verbunden ist und
- daß der Stromversorgungs-Ausgang des zweiten HF-Bausteines mit der am Grundpotential liegenden Metallschicht verbunden ist.

Damit ergibt sich eine galvanisch entkoppelte Signalübertragung über Mikrostreifenleitungen. Die beiden HF-Bausteine sind gleichstrommäßig in Reihe geschaltet, wobei gewährleistet ist, daß an jedem Baustein der notwendige Spannungsabfall realisiert werden kann.

In der Zeichnung ist in den Fig. 1 bis 5 ein Ausführungsbeispiel des Gegenstandes gemäß der Erfindung schematisch dargestellt.
Fig. 1 zeigt die Oberseite einer Leiterplatte mit zwei darauf angebrachten IC's,
Fig. 2 zeigt einen Schnitt II-II gemäß Fig. 1,
Fig. 3 zeigt ein elektrisches Prinzip-Schaltbild gemäß Fig. 1 und 2,
Fig. 4 zeigt eine vergrößerte Darstellung Z gemäß Fig. 1, wobei nur die metallische Unterseite der Leiterplatte dargestellt ist, und
Fig. 5 zeigt einen Schnitt V-V gemäß Fig. 4 durch die gesamte Leiterplatte.

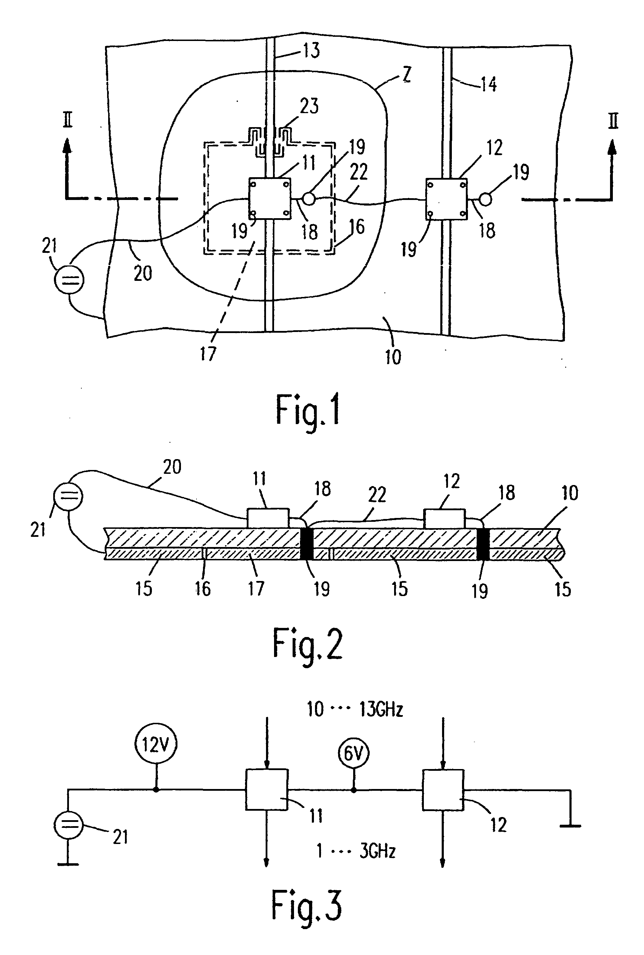

Die teilweise dargestellte Leiterplatte gemäß Fig. 1 und 2 besitzt eine isolierende Tragplatte 10 mit zwei auf ihrer Oberseite angeordneten IC's 11 und 12, die eingangsseitig mit Mikrostreifen-Zuleitungen 13 und 14 verbunden sind. Die Leiterplatte besitzt an der Unterseite der isolierenden Tragplatte eine metallische Schicht 15, die im Bereich des IC's 11 eine durch eine durchgehende Nut 16 abgetrennte metallische Insel 17 bildet, die von der metallischen Schicht 15 galvanisch getrennt ist. Die IC's 11, 12 sind über direkte Verbindungen 18 und Durchmetallisierungen 19 mit der jeweiligen unterhalb der IC's liegenden Insel 17 bzw. Metallschicht 15 verbunden. Dabei ist der Stromversorgungs-Eingang des ersten IC's 11 über eine Gleichstromversorgungsleitung 20 mit einer Gleichspannungsquelle 21 und der Stromversorgungs-Ausgang dieses IC's 11 über die Verbindung 18 und Durchkontaktierung 19 mit der metallischen Insel 17 verbunden. Die metallische Insel 17 ist über eine weitere Stromversorgungsleitung 22 mit dem Stromversorgungs-Eingang des zweiten IC's 12 verbunden, dessen Stromversorgungs-Ausgang über die direkte Verbindung 18 und Durchmetallisierung 19 mit der Metallschicht 15 verbunden ist, die am Gegenpol der Gleichspannungquelle 21 liegt.

Die Hochfrequenzsignale für die IC's 11 und 12 werden über die Mikrostreifenleitungen 13 und 14 zugeführt. Die verlustarme und reflexionsfreie Übertragung des hochfrequenten Signals über die Mikrostreifen-Leitung 13 an der Stelle auf der Unterseite der Trägerplatte 10, an der die Metallschicht 15 unterbrochen ist, ist durch eine Koppelstelle 23 zwischen der Metallschicht 15 und der metallischen Insel 17 im Bereich unterhalb der Mikrostreifen-Leitung 13 gewährleistet.

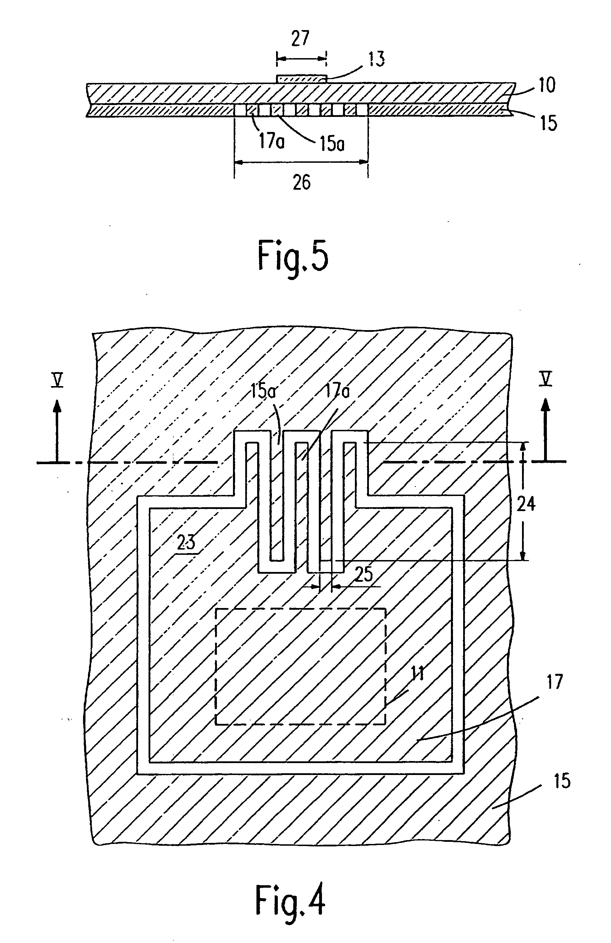

Die Koppelstelle 23 enthält gemäß der vergrößerten Darstellung in Fig. 4 in Richtung der Mikrostreifenleitung 13 verlaufende Stege 17a der metallischen Insel 17 und in entgegengesetzter Richtung verlaufende Stege 15a der Metallschicht 15, wobei die Stege 17a und 15a jeweils kammartig ausgebildet sind und ineinandergreifen.

In Fig. 5 ist ein Querschnitt V-V gemäß Fig. 4 dargestellt. Fig. 4 und 5 sind nicht maßstabsgetreu, sondern in ihren Einzelteilen mehr oder weniger vergrößert dargestellt. Ferner ist die Länge der Stege 17a und 15a sehr viel größer als ihre Breite. Mit 26 ist die Breite der Koppelstelle 23 und mit 27 die Breite der Mikrostreifen-Zuleitung 13 bezeichnet.

Das elektrische Schaltbild gemäß Fig. 3 zeigt die beiden in Reihe geschalteten IC's 11, 12, an denen jeweils eine Spannung von 6 V abfällt, wobei die Gleichspannungsquelle 21 eine Spannung von 12 V aufweist. In diesem Beispiel hat das HF-Eingangssignal eine Frequenz von 10 GHz bis 13 GHz und das HF-Ausgangssignal eine Frequenz von 1 GHz bis 3 GHz.

## Patentansprüche

1. Leiterplatte,
- auf deren Unterseite eine Metallschicht (15) und
- auf deren Oberseite ein erster HF-Baustein (11) und ein zweiter HF-Baustein (12) angeordnet sind, wobei
- der erste und der zweite HF-Baustein eingangsseitig und/oder ausgangsseitig über Mikrostreifen-Zuleitungen (13, 14) mit HF-Quellen, HF-Senken oder anderen HF-Bausteinen und über eine gesonderte Zuleitung (20) mit einer Gleichstromquelle (21) verbindbar sind,
- die Metallschicht im Anschlußbereich des ersten HF-Bausteines (11) durch einen Spalt derart getrennt ist, daß unterhalb des ersten HF-Bausteines (11) eine metallische Insel (17) so gebildet wird, daß keine Gleichstromverbindung mehr zwischen der metallischen Insel (17) und der sie umgebenden Metallschicht (15) auf der Unterseite der Trägerplatte besteht,
- ein Stromversorgungs-Ausgang des ersten HF-Bausteins (11) mit der metallischen Insel (17) verbunden ist,
- die metallische Insel (17) mit einem Stromversorgungs-Eingang des zweiten HF-Bausteins (12) verbunden ist und
- die metallische Insel (17) im Bereich unterhalb einer dem ersten HF-Baustein (11) zugeordneten Mikrostreifen-Zuleitung (13) über eine HF-Koppelstelle (23) HF-mäßig mit der benachbarten Metallschicht (15) gekoppelt ist,
- der erste, oberhalb der metallischen Insel (17) liegende HF-Baustein (11) mit dem zweiten, oberhalb der Metallschicht (15) liegende HF-Baustein (12) gleichstrommäßig in Reihe geschaltet ist,
- die HF-Koppelstelle (23) durch mindestens zwei in Richtung der Mikrostreifen-Zuleitung (13) verlaufende, unmittelbar nebeneinander liegende Stege (17a, 15a) gebildet wird, von denen der eine von der metallischen Insel (17) und der andere von der der benachbarten Metallschicht 15 gebildet ist und wobei wenn der erste und der zweite HF-Baustein an eine gemeinsame Gleichspannungsquelle (21) angeschlossen würden
- wäre der Ausgang der Gleichspannungsquelle (21) mit einem Stromversorgungs-Eingang des ersten HF-Bausteins (11) verbunden und
- der Stromversorgungs-Ausgang des zweiten HF-Bausteins (12) der mit der Metallschicht (15) verbunden ist, würde am Grundpotential liegen.

2. Leiterplatte nach Anspruch 1, **dadurch gekennzeichnet, daß** das Verhältnis der Länge (24) der Stege zur Breite (25) der Stege sehr viel größer ist als 1.

3. Leiterplatte nach Anspruch 1 oder 2, **dadurch gekennzeichnet, daß** die Anzahl der Stege (17a, 15a), die Länge (24) der Stege, die Breite (25) der Stege und die gegenseitigen Abstände der Stege abhängig sind von der Frequenz und Bandbreite der über die Mikrostreifen-Zuleitungen (13) geführten HF-Signale.

4. Leiterplatte nach einem der Ansprüche 1 bis 3, **dadurch gekennzeichnet, daß** die Stege (17a, 15a) jeweils kammartig ausgebildet sind und mäanderförmig ineinandergreifen.

## Claims

1. A printed circuit board having arranged
- on its lower side a metal layer (15) and
- on its upper side a first HF component (11) and a second HF component (12), wherein
- said first and said second HF component are connected by their input and/or output sides via micro ribbon lines (13, 14) to HF sources, HF loads or other HF components and can be connected via a separate connection line (20) to a DC current source (21),
- said metal layer is in the connection region of said first HF component (11) separated by a gap in such way, that underneath of said first HF component (11) a metallic island (17) is formed in such way, that a DC current connection between said metallic island (17) and said metal layer (15) surrounding it on the lower side of said board does not exist any more,
- a current supply output of said first HF component (11) is connected to said metallic island (17),
- said metallic island (17) is connected to a current supply input of said second HF component (12), and
- said metallic island (17) is in the region below a micro ribbon line (13) associated with said first HF component (11) HF connected via an HF coupling (23) to the adjoining metal layer (15),
- said first HF component (11) situated above said metallic island (17) is DC connected in series with said second HF component (12) situated above said metal layer (15),
- said HF coupling (23) is formed by at least two projections (17a, 15a) running in the direction of said micro ribbon line (13) and lying immediately next to each other, one of which being formed by said metallic island (17) and the other being formed by the adjoining metal layer (15) and wherein
- if said first and second HF component were connected to a common DC voltage source (21),
- the current supply output of said DC voltage source (21) would be connected to a voltage supply input of said first HF component (11) and
- the voltage supply output of said second HF component (12), which is connected to said metallic layer (15), would be lying at ground potential.

2. Printed circuit board according to claim 1, **characterized in that** the ratio of the length (24) of said projections to the width (25) of said projections is much greater than 1.

3. Printed circuit board according to claim 1 or 2, **characterized in that** the number of said projections (17a, 15a), the length (24) of said projections, the width (25) of said projections and the mutual spacings of said projections are dependent on the frequency and the bandwidth of the HF signals lead over said micro ribbon lines (13).

4. Printed circuit board according to one of the claims1 to 3, **characterized in that** said projections (17a, 15a) in each case are comb-shaped and grip into one another in a meander-type arrangement.

## Revendications

1. Carte imprimée
- sur la face inférieure de laquelle une couche métallique (15) et
- sur la face supérieure de laquelle un premier composant HF (11 ) et un deuxième composant HF (12) sont disposés,
- le premier et le deuxième composant HF pouvant être reliés côté entrée et/ou côté sortie par des câbles à microbandes (13, 14) à des sources HF, des puits HF ou d'autres composants HF et par un câble distinct (20) à une source de courant continu (21),
- la couche métallique étant séparée, au niveau du raccordement du premier composant HF (11), par un intervalle de manière à ce qu'en dessous du premier composant HF (11), un îlot métallique (17) soit formé de manière à ce qu'aucune liaison à courant continu n'existe plus entre l'îlot métallique (17) et la couche métallique (15) l'entourant sur la face inférieure du support,
- une sortie d'alimentation en courant du premier composant HF (11 ) étant reliée à l'îlot métallique (17),
- l'îlot métallique (17) étant relié à une entrée d'alimentation en courant du deuxième composant HF (12) et
- l'îlot métallique (17) étant, dans la zone située en dessous d'un câble à microbandes (13) associé au premier composant HF (11), couplé par un point de couplage HF (23) au niveau HF avec la couche métallique voisine (15),
- le premier composant HF (11 ) se trouvant au dessus de l'îlot métallique (11 ) étant branché en série en courant continu avec le deuxième composant HF (12) se trouvant au dessus de la couche métallique (15),
- le point de couplage HF (23) étant formé par au moins deux traverses (17a, 15a) s'étendant en direction du câble à microbandes (13) et situées directement l'une près de l'autre, dont l'une est formée par l'îlot métallique (17) et l'autre par la couche métallique voisine (15) et sachant que,
- si le premier et le deuxième composants HF étaient raccordés à une source de tension continue commune (21),
- la sortie de la source de tension continue (21) serait reliée à une entrée d'alimentation en courant du premier composant HF (11) et
- la sortie d'alimentation en courant du deuxième composant HF (12) qui est reliée à la couche métallique (15) se trouverait au potentiel de base.

2. Carte imprimée selon la revendication 1, **caractérisée en ce que** le rapport de la longueur (24) des traverses à la largeur (25) des traverses est beaucoup plus grand que 1.

3. Carte imprimée selon la revendication 1 ou 2, **caractérisée en ce que** le nombre de traverses (17a, 15a), la longueur (24) des traverses, la largeur (25) des traverses et les écarts réciproques entre les traverses dépendent de la fréquence et de la largeur de bande des signaux HF guidés par les câbles à microbandes (13).

4. Carte imprimée selon l'une quelconque des revendications 1 à 3, **caractérisée en ce que** les traverses (17a, 15a) sont conformées respectivement en forme de peigne et s'engrènent les unes dans les autres suivant une forme sinueuse.
